# FASCICULE DE BREVET EUROPEEN

(11) **EP 2 780 774 B1**
(45) Date de publication et mention de la délivrance du brevet: **05.12.2018**
(21) Numéro de dépôt: 12778743.0
(22) Date de dépôt: 30.10.2012
(51) Int. Cl.: G06F 1/16, H01L 23/467

(54) **APPAREIL ELECTRONIQUE DE TYPE MODEM OU ANALOGUE COMPORTANT PLUSIEURS PROCESSEURS REFROIDIS PAR AIR**
ELEKTRONISCHE VORRICHTUNG, WIE EIN MODEM ODER DERGLEICHEN, MIT MEHREREN LUFTGEKÜHLTEN PROZESSOREN
ELECTRONIC APPARATUS, SUCH AS A MODEM OR THE LIKE, COMPRISING A PLURALITY OF AIR-COOLED PROCESSORS

(30) Priorité: 18.11.2011 FR 1160549
(43) Date de publication de la demande: 24.09.2014
(73) Titulaire: Sagemcom Broadband SAS, 92500 Rueil-Malmaison (FR)
(72) Inventeur: KOHN, Stéphane, F-92500 Rueil Malmaison (FR)
(74) Mandataire: Lavialle, Bruno François Stéphane
(86) Numéro de dépôt international: PCT/EP2012/071451
(87) Numéro de publication internationale: WO 2013/072180

(56) Documents cités:
- US-A- 5 544 012
- US-A- 5 986 882
- US-A1- 2006 087 810

## Description

L'invention concerne d'une manière générale l'optimisation du refroidissement d'un appareil électronique comportant plusieurs processeurs.

### ARRIERE PLAN DE L'INVENTION

L'invention s'applique notamment à un appareil multimédia tel qu'un modem un décodeur ou analogue, comme par exemple une "set top box", c'est-à-dire un appareil destiné à être connecté à un modem de type DSL et à un téléviseur pour convertir un signal de contenu audiovisuel issu du modem en un signal exploitable par un téléviseur pour affichage de ce contenu.

Un tel appareil élecronique intègre généralement un ou plusieurs ventilateurs pour refroidir ses composants par établissement d'une circulation d'air forcée à l'intérieur de son enceinte.

Du fait de sa fonction, un tel appareil est généralement installé à proximité du téléviseur auquel il est connecté, de sorte qu'il est nécessaire que le bruit de fond généré par son ou ses ventilateurs de refroidissement soit le plus faible possible, sans quoi sa présence perturbe significativement le confort de l'utilisateur regardant un programme sur son téléviseur.

Comme on le comprend un tel appareil peut aussi bien etre relié à un ordinateur, à un lecteur audio-video, à une console de jeu, ou à tout type d'appareil. Les documents US20080041562 et US20030218850 concernent le refroidissement d'un appareil électronique selon l'état de la technique.

### OBJET DE L'INVENTION

Le but de l'invention est de proposer une solution pour assurer un refroidissement à la fois efficace et silencieux d'un tel appareil électronique.

### RESUME DE L'INVENTION

A cet effet, l'invention a pour objet un appareil électronique, de type modem, décodeur ou analogue, comportant un ventilateur et un carter interne canalisant le flux d'air généré par ce ventilateur, et plusieurs circuits intégrés tels que des processeurs équipés de radiateurs qui sont montés dans l'appareil de sorte que leurs radiateurs sont situés en regard de différentes portions de la section transversale du flux d'air canalisé, pour que les différents radiateurs soient refroidis par différentes portions du flux d'air.

Avec cette architecture, les différents processeurs reçoivent de l'air qui est sensiblement à la même température, de sorte qu'ils peuvent tous être refroidis efficacement sans qu'il soit nécessaire de recourir à plusieurs ventilateurs.

L'invention a également pour objet un appareil ainsi défini, dans lequel les radiateurs des circuits intégrés sont espacés les uns des autres le long du flux d'air généré par le ventilateur.

L'invention a également pour objet un appareil ainsi défini, comportant au moins deux circuits intégrés ayant leurs radiateurs orientés tête-bêche.

L'invention a également pour objet un appareil ainsi défini, dans lequel le carter a une forme qui canalise le flux d'air du ventilateur de façon rectiligne.

L'invention a également pour objet un appareil ainsi défini, comportant deux circuits intégrés portés par deux cartes électroniques distinctes superposées parallèles l'une à l'autre, et dans lequel le carter est interposé entre ces deux cartes et comporte deux parois latérales parallèles situées de part et d'autre des deux circuits intégrés en s'étendant perpendiculairement aux cartes électroniques.

L'invention a également pour objet un appareil ainsi défini, dans lequel le carter est pourvu d'au moins un rétrécissement pour adapter localement le débit d'air au radiateur d'un circuit intégré.

L'invention a également pour objet un appareil ainsi défini, dans lequel le carter comporte en outre une ou plusieurs ouvertures latérales pour dévier une partie de l'air issu du ventilateur vers des composants autres que les radiateurs de circuits intégrés.

### BREVE DESCRIPTION DES FIGURES

- La figure 1 est une vue en perspective des différents éléments constitutifs de l'appareil selon l'invention ;
- la figure 2 est une vue en perspective et en coupe longitudinale montrant les éléments constitutifs de l'appareil selon l'invention selon un plan de coupe passant par le carter ;
- la figure 3 est une vue en perspective montrant la partie supérieure du carter représenté seul ;
- la figure 4 est une vue en perspective montrant la partie inférieure du carter représenté seul.

### DESCRIPTION DETAILLEE DE L'INVENTION

L'idée à la base de l'invention est de faire en sorte que différentes portions du flux d'air généré par un même ventilateur refroidissent différents processeurs, de telle manière que ces différents processeurs reçoivent de l'air de refroidissement à même température.

Dans l'exemple des figures, l'invention est appliquée à un appareil électronique 1 destiné à être interposé entre un modem et un téléviseur pour convertir des signaux issus du modem afin de les rendre exploitables par le téléviseur.

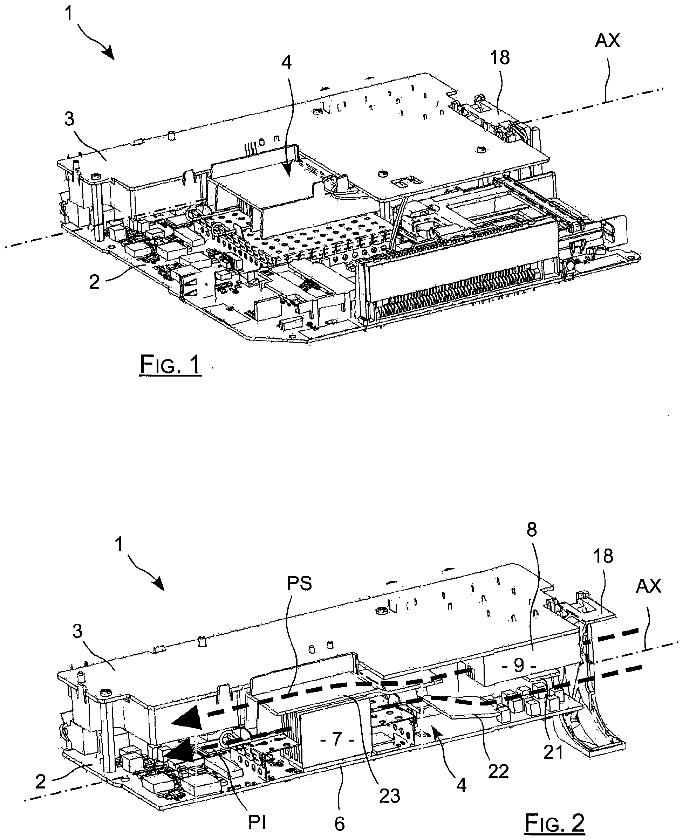

Comme visible dans la figure 1, cet appareil comporte une carte électronique principale 2, ou carte inférieure, supportant une carte électronique secondaire 3, ou carte supérieure, s'étendant parallèlement à la carte principale en étant espacée de celle-ci, ainsi qu'un carter 4 qui est interposé entre ces deux cartes électroniques.

Ce carter 4 est une pièce en matière plastique ayant une forme générale allongée qui s'étend selon une direction correspondant à celle d'un axe repéré par AX dans les figures, et qui est parallèle aux cartes 2 et 3.

Comme visible à la figure 2, les cartes 2 et 3 portent différents composants dont en particulier un processeur inférieur 6 avec son radiateur 7 qui est porté par la carte principale 2, et un processeur supérieur 8 avec son radiateur 9 qui est porté par l'autre carte, à savoir la carte 3 qui est située au dessus de la carte 2.

Le radiateur 7 tout comme le radiateur 9 sont ici des radiateurs en aluminium rapportés à la face externe des processeurs 6 et 8, respectivement, et chacun de ces radiateurs comporte principalement une série d'ailettes parallèles les unes aux autres et s'étendant selon la direction AX en étant espacées les unes des autres transversalement à cette direction AX. Ces radiateurs peuvent aussi bien être du type à picots.

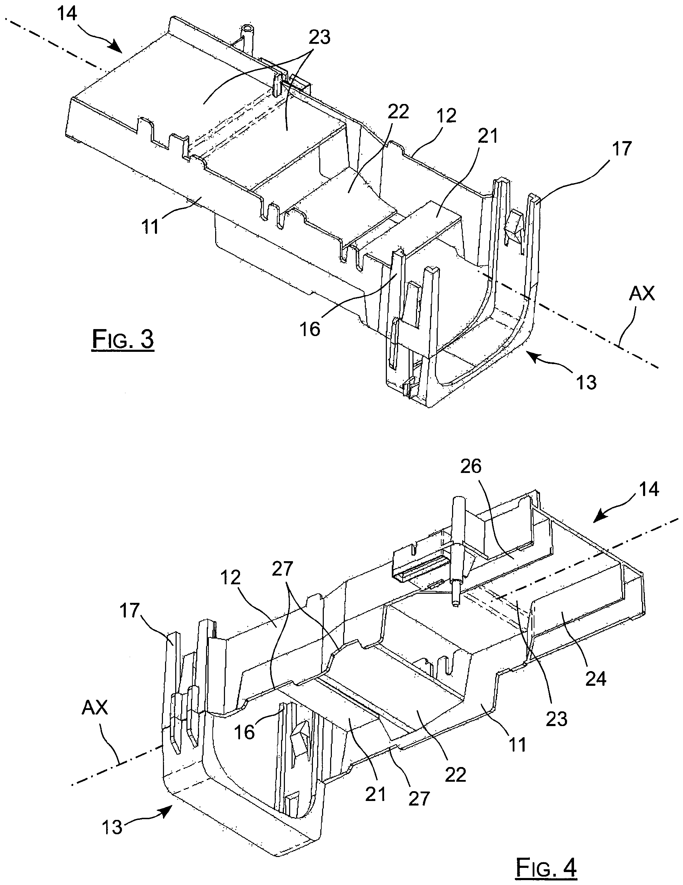

Le carter 4 comporte principalement deux parois latérales parallèles l'une à l'autre qui s'étendent selon la direction AX en étant espacées l'une de l'autre transversalement à cette direction AX. Chacune de ces parois, qui sont repérées par 11 et 12 dans la figure 3, s'étend depuis la carte 2 jusqu'à la carte 3.

Le carter 4 s'étend depuis une région correspondant à deux bords parallèles des cartes électroniques 2 et 3, où débouche une extrémité 13 d'admission d'air de ce carter 4, jusqu'à une région centrale de l'ensemble constitué par les deux cartes 2 et 3 et où se trouve l'extrémité d'évacuation 14 de ce carter 4.

Les deux processeurs 6 et 8 avec leurs radiateurs respectifs 7 et 9 sont montés dans cet ensemble de manière à être espacés le long de l'axe AX, tout en étant orientés tête-bêche.

Comme visible dans les figures 1 et 3, le processeur inférieur 6 est porté par la face supérieure de la carte principale 2 en étant situé dans une région centrale de cette carte et entouré par les parois 11 et 12 du carter 4 au niveau de son extrémité 14, et son radiateur 8 a ses ailettes dirigéees vers le haut, c'est-à-dire vers la face inférieure de la carte secondaire 3.

Le processeur supérieur 8 est quant à lui porté par la face inférieure de la carte secondaire 3 en étant entouré par les parois 11 et 12, et il est proche de l'extrémité d'admission 13. Le radiateur 9 de ce processeur 8 a ses ailettes dirigées vers le bas, c'est-à-dire vers la face supérieure de la carte principale 3.

Comme visible dans les figures 3 et 4, l'extrémité ou embouchure d'admission 13 du carter 4 a une forme de berceau conçu pour recevoir un ventilateur fixé par encliquetage. A cet effet, cette extrémité 13 comporte deux bras parallèles 16 et 17 pourvu chacun d'un ergot, ces deux ergots étant dirigés l'un vers l'autre.

L'installation du ventilateur, qui est partiellement visible dans les figures 1 et 2 en y étant repéré par 18, consiste ainsi simplement à l'engager entre les deux bras 16 et 17, jusqu'à ce qu'il s'encliquette pour être bloqué en position par les ergots que portent ces bras.

Comme visible dans les différentes figures, le carter 4 constitue, conjointement avec la carte inférieure 2 et avec la carte supérieure 3 entre lesquelles il est interposé, un guide d'air pour canaliser l'air admis par le ventilateur 18 selon la direction AX, afin de lui faire refroidir efficacement les processeurs 6 et 8.

Compte tenu du montage des processeurs 6 et 8 tête-bêche, le processeur inférieur 6 avec son radiateur 7 est situé en vis-à-vis d'une portion inférieure du flux d'air canalisé par le carter 4, alors que le processeur supérieur 8 avec son radiateur 9 est situé en vis-à-vis ou en regard d'une portion supérieure de ce flux d'air. Il est également possible de prévoir un agencement dans lequel les processeurs seraient montés côte à côte sur une même carte en étant refroidis par des portions distinctes du flux d'air généré par le ventilateur 18.

Ainsi, en fonctionnement, c'est-à-dire lorsque le ventilateur 18 est activé pour aspirer de l'air extérieur afin de l'introduire dans le guide que constitue le carter 4 et en direction de l'extrémité d'extraction 13 de ce carter, la portion inférieure de ce flux d'air refroidit le radiateur 7 du processeur inférieur 6, alors que la portion supérieure de ce flux d'air refroidit le radiateur 9 du processeur supérieur 8.

Les radiateurs 7 et 9 étant refroidis par des portions distinctes du flux d'air issu du ventilateur 18, ils reçoivent l'un et l'autre de l'air qui est sensiblement à la même température, ce qui permet de refroidir avec sensiblement la même efficacité ces deux radiateurs. Autrement dit, grâce à l'invention, il n'est pas nécessaire de favoriser un processeur plutôt que l'autre en matière de refroidissement.

Comme indiqué plus haut et visible dans les figures 3 et 4, le carter ou guide d'air 4 comporte deux parois longitudinales 11 et 12, qui s'étendent verticalement par rapport aux cartes 2 et 3, et qui sont réunies l'une à l'autre par trois portions sensiblement parallèles aux cartes 2 et 3, ces trois portions étant repérées par 21, 22 et 23.

La première de ces trois portions, repérée par 21 est un pont rigidificateur qui réunit les deux parois 11 et 12 au voisinage de l'extrémité d'admission 13 afin de la rigidifier mécaniquement. Ce pont étant situé sensiblement au droit du processeur supérieur 8, en étant à peu près à mi-hauteur du carter 4, de sorte qu'il correspond sensiblement à la séparation entre la portion supérieure du flux d'air de refroidissement, et la portion inférieure du flux d'air de refroidissement.

Concrètement, la portion supérieure du flux d'air de refroidissement issu du ventilateur 18 passe au dessus de ce pont 21, lorsqu'elle traverse le radiateur 9 du processeur supérieur 8.

La deuxième de ces trois portions, repérée par 22, est un déflecteur situé dans la région inférieure du guide que constitue le carter 4 : ce déflecteur est proche de la carte électronique inférieure 2 qui porte ce carter 4, tout en étant incliné par rapport à cette carte de manière à réduire verticalement la section de passage du flux d'air au fur et à mesure qu'il progresse vers l'extrémité d'évacuation 13. Ainsi, l'inclinaison du déflecteur 22 tend à dévier sensiblement le flux d'air de refroidissement vers la carte supérieure 3.

La troisième portion 23 constitue une rampe d'extraction qui est située dans la région supérieure du carter 4, en étant au dessus du processeur inférieur 6 et de son radiateur 7. Cette rampe 23 est légèrement inclinée, dans le même sens que le déflecteur 22, pour évacuer vers le haut la portion supérieure du flux d'air, c'est-à-dire la portion du flux ayant refroidi le processeur supérieur 8.

Pour faciliter encore l'évacuation de la portion de flux d'air ayant refroidi le processeur supérieur 8, la carte électronique secondaire ou supérieure 3 est ouverte au droit du processeur inférieur 6 et de son radiateur 7, c'est-à-dire sur la majeure partie de la rampe d'extraction 23, ce qui permet par exemple d'extraire l'air de refroidissement du processeur supérieur 8 directement, par exemple vers une grille d'évacuation prévue à cet effet au niveau du boîtier non représenté entourant l'ensemble représenté en figure 1.

Complémentairement, et comme illustré en particulier dans la figure 4, le carter 4 comporte encore deux cloisons 24 et 26, situées sous la rampe 23 et s'étendant parallèlement aux parois 11 et 12 en étant espacées de celles-ci. Ces deux cloisons 24 et 26 délimitent ainsi conjointement une restriction de la largeur de la portion inférieure du flux d'air, c'est-à-dire la portion de flux d'air refroidissant le radiateur 7 du processeur inférieur 6.

Ainsi, comme on le comprend, la section de passage de la portion inférieure du flux d'air, c'est-à-dire la portion de flux d'air qui refroidit le processeur inférieur 6, est restreinte d'une part verticalement par le déflecteur 22, et d'autre part horizontalement par les cloisons 24 et 26.

En pratique, les restrictions de section que constituent le déflecteur 22 et les cloisons 24 et 26 permettent d'accélérer la portion inférieure du flux d'air de refroidissement pour qu'il traverse le radiateur 7 à une vitesse plus grande, améliorant de la sorte le débit d'air, et par là même, l'efficacité de l'échange thermique.

D'une manière générale, le guide d'air que constitue le carter 4 divise le flux d'air produit par le ventilateur 18 en une portion supérieure et une portion inférieure représentées dans la figure 2 par des flèches en traits pointillés repérées respectivement par PS et PI.

La portion supérieure PS, qui correspond ici sensiblement à la moitié supérieure du flux d'air produit par le ventilateur 18, traverse en premier lieu le radiateur 9 du processeur supérieur 8, en passant au dessus du pont 21, puis elle est collectée par la rampe 23 pour être évacuée vers la partie supérieure de l'extrémité d'évacuation 14 du carter 4.

La portion inférieure PI du flux d'air généré par le ventilateur 18 correspond ici sensiblement à la moitié inférieure de ce flux. Elle passe sous le radiateur 9 en longeant sensiblement la face inférieure du pont 21, avant d'être déviée par le déflecteur incliné 22 qui réduit verticalement sa section de passage pour l'accélérer. Cette portion inférieure PI passe ensuite à travers le radiateur 7 du processeur inférieur 6 de manière à le refroidir, attendu qu'au niveau de ce radiateur 7, la section de passage de cette portion inférieure PI est réduite latéralement grâce aux deux cloisons 24 et 26, ce qui permet d'augmenter encore sa vitesse.

Complémentairement, les parois 11 et 12 comportent chacune des évidements 27 au niveau de leurs arêtes inférieurs, c'est-à-dire au niveau des arêtes qui sont en contact avec la carte électronique de base 2 lorsque le système est monté, de manière à dévier hors du carter 4 de l'air de refroidissement pour assurer le refroidissement des composants de l'appareil autres que ses processeurs 6 et 8.

Concrètement, chaque évidement 27 a une forme d'arcade ou analogue constituant une ouverture latérale que l'air injecté dans le guide 4 par le ventilateur 18 peut traverser pour être dirigé entre les deux cartes 2 et 3 afin d'en refroidir les différents composants.

Le carter 4 est solidarisé aux cartes électroniques 2 et 3 grâce à un montage mécanique utilisant notamment différents plots, encoches ou analogues, repérés par 28, et qui dépassent de la partie supérieure et de la partie inférieure de ce carter pour s'enficher dans des logements correspondants prévus à cet effet au niveau des cartes électroniques 2 et 3 qui enserrent ce carter 4 pour former un guide d'air.

Dans la construction retenue sur l'exemple des figures, le flux d'air généré par le ventilateur 18 est canalisé pour suivre dans le carter 4 une trajectoire rectiligne alignée avec les processeurs 6 et 8, de sorte que cet air subit peu de pertes de charges, ce qui permet de réduire le niveau de bruit que génère le refroidissement, et d'augmenter l'efficacité du flux d'air en matière de refroidissement.

## Revendications

1. Appareil électronique (1), de type modem, décodeur ou analogue, comportant un ventilateur (18) et un carter interne (4) canalisant le flux d'air généré par ce ventilateur (18), et plusieurs circuits intégrés tels que des processeurs (6, 8) équipés de radiateurs (7, 9) qui sont montés dans l'appareil (1) de sorte que leurs radiateurs (7, 9) sont situés en regard de différentes portions (PS, PI) de la section transversale du flux d'air canalisé, pour que les différents radiateurs (7, 9) soient refroidis par différentes portions (PS, PI) du flux d'air, le carter (4) comportant en outre une ou plusieurs ouvertures latérales (27) pour dévier une partie de l'air issu du ventilateur (18) vers des composants autres que les radiateurs (7, 9) de circuits intégrés (6, 8).

2. Appareil selon la revendication 1, dans lequel les radiateurs (7, 9) des circuits intégrés (6, 8) sont espacés les uns des autres le long du flux d'air généré par le ventilateur.

3. Appareil selon l'une des revendications précédentes, comportant au moins deux circuits intégrés (6, 8) ayant leurs radiateurs (7, 9) orientés tête-bêche.

4. Appareil selon l'une des revendications précédentes, dans lequel le carter (4) a une forme qui canalise le flux d'air du ventilateur (18) de façon rectiligne.

5. Appareil selon l'une des revendications précédentes, comportant deux circuits intégrés (6, 8) portés par deux cartes électroniques (2, 3) distinctes superposées parallèles l'une à l'autre, et dans lequel le carter (4) est interposé entre ces deux cartes (2, 3) et comporte deux parois latérales (11, 12) parallèles situées de part et d'autre des deux circuits intégrés (6, 8) en s'étendant perpendiculairement aux cartes électroniques (2, 3).

6. Appareil selon l'une des revendications précédentes, dans lequel le carter (4) est pourvu d'au moins un rétrécissement (22, 24, 26) pour adapter localement le débit d'air au radiateur (7) d'un circuit intégré (6).

## Patentansprüche

1. Elektronisches Gerät, der Art Modem, Decoder oder dergleichen, umfassend einen Lüfter (18) und ein Innengehäuse (4), das den von diesem Lüfter (18) erzeugten Luftstrom kanalisiert, sowie mehrere integrierte Schaltkreise, wie z. B. mit Radiatoren (7, 9) ausgestattete Prozessoren (6, 8), die in dem Gerät (1) derart montiert sind, dass sich ihre Radiatoren (7, 9) gegenüber unterschiedlichen Abschnitten (PS, PI) des Querschnitts des kanalisierten Luftstroms befinden, damit die verschiedenen Radiatoren (7, 9) von unterschiedlichen Abschnitten (PS, PI) des Luftstroms gekühlt werden, wobei das Gehäuse (4) ferner eine oder mehrere seitliche Öffnungen (27) umfasst, um einen Teil der aus dem Lüfter (18) stammenden Luft in Richtung anderer Komponenten als den Radiatoren (7, 9) der integrierten Schaltkreise (6, 8) umzuleiten.

2. Gerät nach Anspruch 1, bei dem die Radiatoren (7, 9) der integrierten Schaltkreise (6, 8) entlang des von dem Lüfter erzeugten Luftstroms zueinander beabstandet sind.

3. Gerät nach einem der vorhergehenden Ansprüche, umfassend mindestens zwei integrierte Schaltkreise (6, 8), deren Radiatoren (7, 9) entgegengesetzt ausgerichtet sind.

4. Gerät nach einem der vorhergehenden Ansprüche, bei dem das Gehäuse (4) eine Form hat, die den Luftstrom des Lüfters (18) auf geradlinige Weise kanalisiert.

5. Gerät nach einem der vorhergehenden Ansprüche, umfassend zwei integrierte Schaltkreise (6, 8), die von zwei unterschiedlichen Leiterplatten (2, 3) getragen werden, die parallel zueinander übereinander angeordnet sind, und bei dem das Gehäuse (4) zwischen diesen beiden Leiterplatten (2, 3) angeordnet ist und zwei parallele seitliche Wände (11, 12) umfasst, die sich zu beiden Seiten der beiden integrierten Schaltkreise (6, 8) befinden, während sie sich senkrecht zu den Leiterplatten (2, 3) erstrecken.

6. Gerät nach einem der vorhergehenden Ansprüche, bei dem das Gehäuse (4) mit mindestens einer Verengung (22, 24, 26) versehen ist, um die Luftmenge zum Radiator (7) eines integrierten Schaltkreises (6) lokal anzupassen.

## Claims

1. An electronic appliance (1) of modem, decoder, or analogous type, comprising a fan (18) and an internal casing (4) channeling the air stream generated by the fan (18), together with a plurality of integrated circuits such as processors (6, 8) fitted with radiators (7, 9) that are mounted in the appliance (1) so that their radiators (7, 9) are situated in register with different portions (PS, PI) of the cross-section of the channeled air stream so that the different radiators (7, 9) are cooled by different portions (PS, PI) of the air stream, the casing (4) also includes one or more side openings (27) for deflecting a fraction of the air from the fan (18) towards components other than the radiators (7, 9) of the integrated circuits (6, 8).

2. An appliance according to claim 1, wherein the radiators (7, 9) of the integrated circuits (6, 8) are spaced apart from one another along the air stream generated by the fan.

3. An appliance according to any preceding claim, including at least two integrated circuits (6, 8) having their radiators (7, 9) oriented in opposite directions.

4. An appliance according to any preceding claim, wherein the casing (4) is of a shape that channels the stream of air from the fan (18) in rectilinear manner.

5. An appliance according to any preceding claim, having two integrated circuits (6, 8) carried by two distinct electronic cards (2, 3) that are superposed and parallel to each other, and wherein the casing (4) is interposed between these two cards (2, 3) and has two parallel side walls (11, 12) situated on either side of the two integrated circuits (6, 8), and extending perpendicularly to the electronic cards (2, 3).

6. An appliance according to any preceding claim, wherein the casing (4) has at least one constriction (22, 24, 26) for locally adapting the air flow rate to the radiator (7) of an integrated circuit (6).
